(19) Europäisches Patentamt

**European Patent Office**

**Office européen des brevets**

(11) Numéro de publication: **0 230 801 B1**

(12) **FASCICULE DE BREVET EUROPEEN**

(45) Date de publication de fascicule du brevet: **15.07.92** (51) Int. Cl.⁵: **G01R 31/08**

(21) Numéro de dépôt: **86402623.2**

(22) Date de dépôt: **26.11.86**

54 **Procédé de localisation d'un défaut sur une ligne électrique.**

(30) Priorité: **30.12.85 FR 8519433**

(43) Date de publication de la demande:
**05.08.87 Bulletin 87/32**

(45) Mention de la délivrance du brevet:
**15.07.92 Bulletin 92/29**

(84) Etats contractants désignés:
**CH DE FR GB LI SE**

(56) Documents cités:
**DE-A- 2 112 136**
**FR-A- 2 538 122**
**US-A- 3 462 681**

(73) Titulaire: **SCHLUMBERGER INDUSTRIES**
**50, avenue Jean Jaurès**
**F-92120 Montrouge(FR)**

(72) Inventeur: **Souillard, Michel**
**16, rue des Fauvettes**
**F-92260 Fontenay Aux Roses(FR)**

(74) Mandataire: **Weinmiller, Jürgen et al**
**Lennéstrasse 9 Postfach 24**
**W-8133 Feldafing(DE)**

Rank Xerox (UK) Business Services

EP 0 230 801 B1

## Description

La présente invention concerne la localisation de défaut sur une ligne électrique d'un réseau de transport d'énergie électrique pour déterminer la distance entre une extrémité de la ligne et un défaut affectant cette ligne.

Dans des procédés de localisation connus, des signaux de mesure de valeurs instantanées de courant et de tension au point de mesure sont produits, et la loi d'Ohm est appliquée à la ligne en défaut. La résistance et l'inductance linéiques de la ligne électrique étant connues, la distance entre le point de mesure et le défaut est déterminée après élimination de l'inconnue que constitue la résistance du défaut.

On connaît en outre, par le document DE-A-2112136, un procédé de localisation d'un défaut sur une ligne électrique à partir de mesures instantanées effectuées à chaque extrémité de la ligne sur laquelle un défaut a été détecté, la distance du défaut par rapport à une extrémité de la ligne étant calculée à partir des valeurs dès mesures instantanées effectuées et de la valeur de l'impédance de la ligne.

L'invention a pour but de fournir un nouveau procédé de localisation de défaut permettant, par des mesures simples, d'effectuer une localisation précise d'un défaut sur une ligne électrique indépendamment de la résistance du défaut et sans faire intervenir de caractéristiques de la ligne mal définies ou sujettes à variations.

La présente invention a pour objet un procédé de localisation de défaut sur une ligne électrique à partir de mesures effectuées à chaque extrémité de la ligne sur laquelle un défaut a été détecté, la distance du défaut par rapport à une extrémité de la ligne étant calculée à partir desdites valeurs reçues et de la valeur de l'impédance de la ligne, lesdites valeurs étant reçues en un même point, ce procédé étant essentiellement caractérisé en ce que les mesures effectuées sont des mesures de grandeurs de transition non homopolaires, le défaut étant assimilé à une source de tension, en ce que les valeurs utilisées sont les valeurs soit des grandeurs de transition mesurées soit des grandeurs scalaires élaborées à partir des grandeurs de transition, la distance du défaut par rapport à une extrémité de la ligne étant calculée à partir des valeurs reçues et de la valeur de l'impédance de la ligne dans le mode correspondant aux grandeurs mesurées.

Le procédé de localisation selon l'invention est basé sur le principe du défaut générateur, c'est-à-dire en considérant le défaut comme une source de tension et, connaissant l'impédance linéique de la ligne, en déterminant l'emplacement du défaut en fonction de la chute de tension entre le point de défaut et chaque extrémité du tronçon de ligne.

Ce procédé présente plusieurs avantages.

D'abord, la localisation est indépendante de la résistance de défaut et le procédé peut s'appliquer à tous types de défauts : dissymétriques à la terre, isolés, ou même symétriques triphasés.

Ensuite, par le choix de grandeurs de transition non homopolaires, la localisation est réalisée indépendamment des caractéristiques d'impédance homopolaire de la ligne, même pour des défauts monophasés à la terre. Il s'agit là d'une caractéristique importante du procédé car l'impédance homopolaire d'une ligne est généralement mal définie et peut être variable dans le temps, en particulier en fonction des conditions climatiques.

Les grandeurs de transition sont consituées par des différences entre valeurs de tension et de courant après apparition du défaut et valeurs des mêmes tension et courant avant apparition du défaut.

Différents types de grandeurs de transition peuvent être utilisés pour la mise en oeuvre du procédé selon l'invention.

Ainsi, pour des lignes symétriques ou transposées, on pourra utiliser des courants et tensions directs de transition. Les grandeurs mesurées à chaque extémité de ligne sont les composantes directes du courant et de la tension, et c'est l'impédance linéique directe de la ligne qui est utilisée pour calculer la distance du défaut. Tous types de défauts dissymétriques ou triphasés peuvent alors être localisés, et ce sans qu'une sélection de la phase de la boucle en défaut soit nécessaire.

Toujours dans le cas de lignes symétriques ou transposées, on pourra utiliser des courants et tension inverses qui constituent en eux-mêmes des grandeurs de transition. Ce sont alors les composantes inverses du courant et de la tension qui sont mesurées à chaque extrémité de ligne, et c'est l'impédance linéique inverse (normalement égale à l'impédance linéique directe) qui est utilisée pour le calcul de la distance du défaut. Comme dans le cas des grandeurs directes de transition, une sélection de phase n'est pas nécessaire.

Parmi les autres types de grandeurs de transition utilisables, on peut citer les courants et tensions polaires de transition, les courants et tensions de phase de transition et les courants et tensions interphases de transition. Une sélection de phase de la boucle en défaut est alors nécessaire pour effectuer les mesures et, éventuellement, sélectionner le paramètre d'impédance de ligne.

2

Le procédé utilisant les courants et tensions polaires de transition s'applique à tous types de défaut et utilise le paramètre d'impédance polaire qui est identique au paramètre d'impédance directe ou inverse dans le cas de lignes symétriques ou transposées.

Le procédé utilisant les courants et tensions interphases de transition s'applique à tous défauts polyphasés et utilise les paramètres d'impédance interphases de la ligne qui peuvent être différents pour une ligne dissymétrique non transposée.

A propos des lignes dissymétriques non transposées, on notera qu'en toute rigueur les grandeurs et caractéristiques à prendre en compte devraient être celles de l'un des trois modes des impédances de ligne.

Quelles que soient les grandeurs mesurées, le calcul de la distance du défaut est effectué en un point où sont reçues les valeurs de ces grandeurs ou de grandeurs scalaires élaborées à partir de celles-ci.

Par exemple, le calcul est effectué à une extrémité de ligne ; les valeurs obtenues à cette extrémité sont directement disponibles tandis que les valeurs obtenues à l'autre extrémité sont reçues par un système de transmission, par exemple par codage éventuel, modulation, et transmission sur un canal de communication. Des moyens de compensation des retards de transmission sont mis en oeuvre lorsque le calcul porte sur des valeurs temporelles, afin de prendre en compte des valeurs simultanées de courants et de tensions aux deux extrémités de ligne.

Les contraintes liées à l'utilisation de valeurs simultanées aux deux extrémités de ligne peuvent être évitées en utilisant non pas des valeurs temporelles, mais des valeurs scalaires. En effet, de telles valeurs scalaires peuvent être élaborées séparément à chaque extrémité de ligne et y être stockées avant transmission en temps différé, avec toute la précision requises, vers le point de calcul.

On pourra par exemple utiliser des grandeurs scalaires homogènes à des énergies par intégration de produits des grandeurs instantanées mesurées avec une même grandeur de référence telle que, par exemple, la tension de service avant défaut ou encore, plus précisément, la valeur de celle-ci au milieu de la ligne.

D'autres particularités et avantages de la présente invention pourront ressortir à la lecture de la description faite ci-après, à titre indicatif mais non limitatif, en référence aux dessins annexés sur lesquels :
- la figure 1 illustre très schématiquement une ligne en défaut,
- la figure 2 illustre la méthode dite du défaut générateur,
- la figure 3 illustre un premier mode particulier de mise en oeuvre du procédé de localisation selon l'invention, et
- la figure 4 illustre un second mode particulier de mise en oeuvre du procédé de localisation selon l'invention.

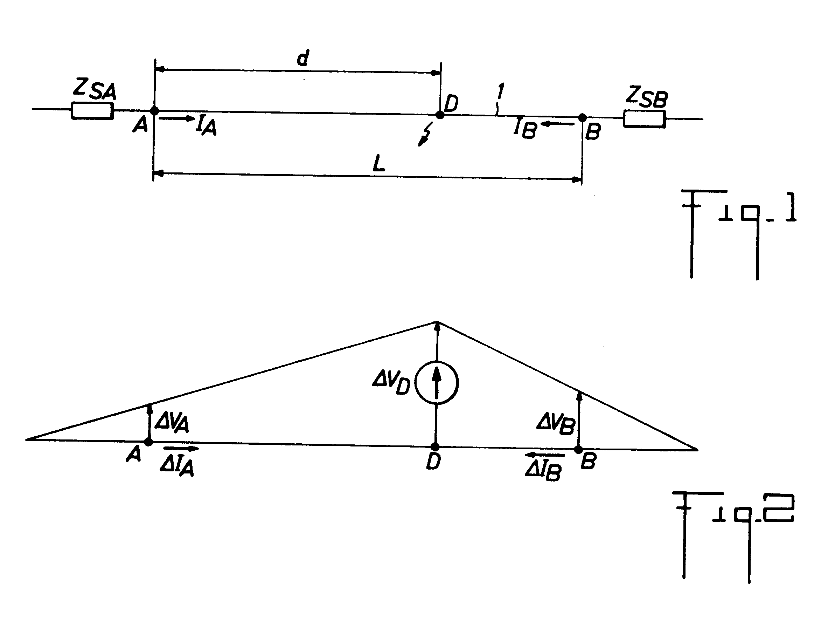

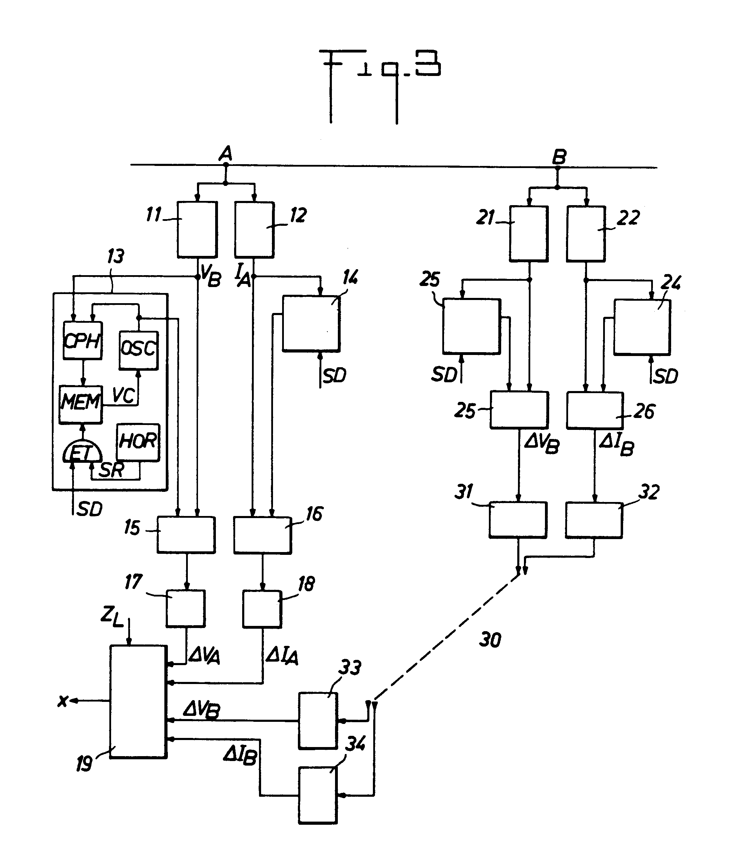

Le procédé selon l'invention sera tout d'abord brièvement décrit dans son principe en référence aux figures 1 et 2.

Sur la figure 1, la référence 1 désigne une ligne électrique surveillée entre deux extrémités A et B distantes d'une longueur L. On suppose qu'un défaut (par exemple défaut entre une ou plusieurs phases et la terre, ou défaut entre phases) existe au point D à une distance d du point A. Les impédances de ligne en amont du point A et en aval du point B sont désignées par $Z_{SA}$ et $Z_{SB}$.

La localisation de défaut par la méthode du défaut générateur dérive du diagramme de tensions de transition de la figure 2. Le défaut est assimilé à une source de tension de transition $\Delta V_D$, de sorte que l'on peut écrire les relations :

(1)    $\Delta V_D = \Delta V_A - x\, Z_L \Delta I_A$, et

(2)    $\Delta V_D = \Delta V_B - (1 - x)\, Z_L \Delta I_B$,

dans lesquelles : $\Delta V_A$ et $\Delta I_A$ sont des tension et courant de transition du point A ; $\Delta V_B$ et $\Delta I_B$ sont des tension et courant de transition au point B, $Z_L$ est une impédance caractéristique de la ligne et x est le rapport entre la distance d et la longueur totale de ligne L. Des relations (1) et (2), il vient :

$$(3) \qquad x = \frac{\Delta V_A - \Delta V_B + Z_L \Delta I_B}{Z_L\,(\Delta I_A + \Delta I_B)}$$

Il est important de noter que chacune des grandeurs $\Delta V_A, \Delta I_A,\ \Delta V_B,\ \Delta I_B$ est une grandeur de transition, c'est-à-dire a une valeur égale à la différence entre sa valeur après défaut et sa valeur avant défaut.

On notera également que le nombre x donné par la relation (3) est indépendant de l'impédance du

défaut. Les termes $\Delta V_A$, $\Delta I_A$, $\Delta V_B$, $\Delta I_B$ sont des nombres complexes, et la relation (3) ne peut être simplifiée en une formule entre les modules des grandeurs que si toutes les impédances du réseau dans lequel se trouve la ligne L ont le même argument.

Si les impédances $Z_{SA}$ et $Z_{SB}$ sont des arguments différents de celui de l'impédance $Z_L$, le calcul de x implique les opérations suivantes :

(a) somme vectorielle des grandeurs du numérateur ($\Delta V_A$ - $\Delta V_B$ + $Z_L \Delta I_B$),

(b) somme vectorielle des grandeurs du dénominateur ($Z_L \Delta I_A$ + $Z_L \Delta I_B$),

(c) mesure des modules N et D du numérateur et du dénominateur,

(d) calcul du quotient x = N/D.

Comme déjà indiqué, les grandeurs de transition mesurées $\Delta V_A$, $\Delta I_A$, $\Delta V_B$, $\Delta I_B$ sont choisies parmi des grandeurs d'un mode non homopolaire, par exemple le mode direct. L'impédance $Z_L$ est alors celle correspondant au mode choisi, cette impédance étant une caractéristique connue de la ligne 1. Le calcul de x nécessite de disposer en un même point des résultats des mesures effectuées aux deux extrémités de la ligne. On supposera que le calcul est effectué au point A, ce qui demande la transmission de B vers A des résultats des mesures effectuées au point B. Cette transmission peut être réalisée par voie radioélectrique. Le procédé selon l'invention est de ce fait particulièrement adapté à être utilisé en combinaison avec un système de protection différentielle de ligne pour lequel il existe des liaisons transmettant les grandeurs de courants entre les extrémités de la ligne. Il est alors seulement nécessaire d'ajouter une voie pour la transmission de grandeurs de tension. Lorsque le calcul de x est effectué sur des valeurs temporelles simultanées des grandeurs aux deux extrémités de la ligne, les dispositifs de compensation de retards de transmission qui sont utilisés dans les sytèmes de protection différentielle permettent de fournir alors également des grandeurs synchrones utilisables pour la localisation. On notera même que la somme $\Delta I_A$ + $\Delta I_B$ qui figure au dénominateur de la fraction donnant x correspond au courant différentiel élaboré pour la protection différentielle.

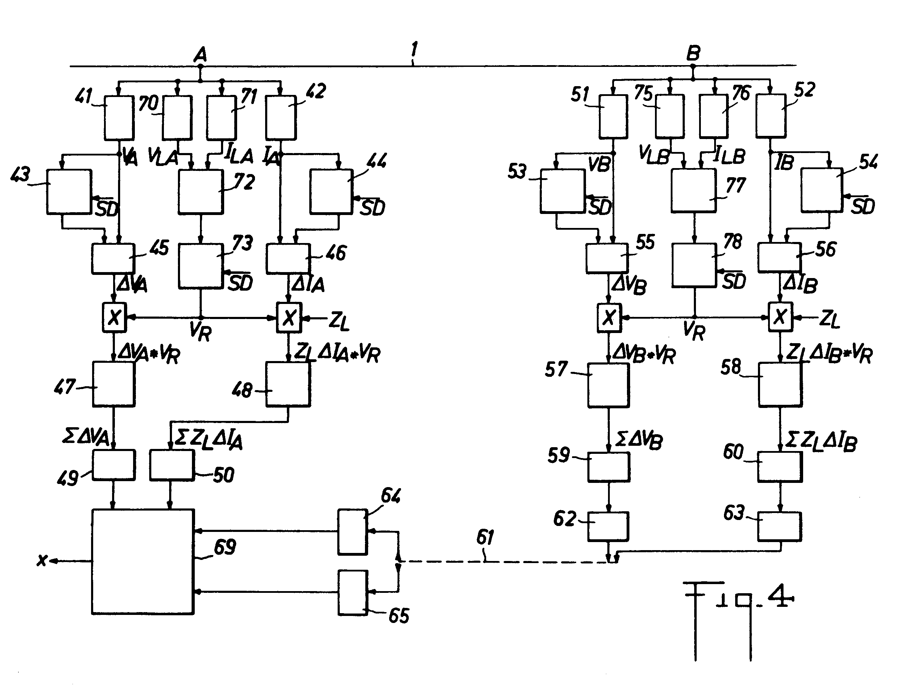

Une mise en oeuvre du procédé selon l'invention avec utilisation des valeurs temporelles des grandeurs de transition mesurées est illustrée par la figure 3.

Des dispositifs de mesure 11, 12 permettent de disposer en temps réel au point A des valeurs des grandeurs dans le mode choisi, par exemple la tension et le courant directs $V_A$, $I_A$. On notera que de tels dispositifs permettant de fournir des grandeurs directes, inverses, polaires de phase, interphases ou autres sont connus et ne nécessitent pas ici de description particulière. Les signaux $V_A$ et $I_A$ sont recopiés au moyen de circuits de mémorisation 13, 14 dont l'état peut être figé à un instant désiré. Les signaux représentatifs de $V_A$ et $I_A$ en sortie des circuits 13, 14 sont appliqués à des soustracteurs respectifs 15, 16 qui reçoivent par ailleurs directement les signaux de sortie des dispositifs de mesure. Dès qu'un défaut est détecté, les états des circuits 13, 14 sont figés sous la commande d'un signal SD fourni par un dispositif de détection de défaut (non représenté). Les circuits 13, 14 délivrent alors des signaux représentatifs des grandeurs $V_A$, $I_A$ avant défaut et l'on dispose donc, en sortie des soustracteurs 15, 16, des valeurs recherchées des grandeurs de transition $\Delta V_A$ et $\Delta I_A$.

Chacun des circuits 13, 14 a ainsi pour fonction de mémoriser la phase et l'amplitude d'un signal de tension ou de courant tel qu'il existait avant le défaut et de délivrer, après l'apparition du défaut, un signal extrapolé représentant le signal de tension ou de courant tel qu'il aurait existé en l'absence de défaut. Ces circuits, réalisés sous forme analogique ou numérique, sont bien connus de l'homme de l'art.

De la même façon, on dispose à l'extrémité B de la ligne de dispositifs de mesures 21, 22 fournissant les valeurs de la tension et du courant directs $V_B$, $I_B$, de circuits de mémorisation 23, 24 destinées à reproduire les valeurs de $V_B$ et $I_B$ avant défaut, et de soustracteurs 25, 26 fournissant les grandeurs de transition $\Delta V_B$, $\Delta I_B$.

Les valeurs mesurées des grandeurs $\Delta V_B$ et $\Delta I_B$ sont appliquées à des émetteurs 31, 32 où elles sont modulées, éventuellement après codage, pour être transmises en temps réel au point A. Les signaux reçus au point A sont démodulés et éventuellement décodés par des récepteurs 33, 34. La transmission entre le point B et le point A est réalisée par un canal de communication 30 en utilisant une voie pour le courant de transition et une autre voie pour la tension de transition. Les valeurs des grandeurs $\Delta V_A$, $\Delta I_A$, $\Delta V_B$ et $\Delta I_B$ sont appliquées à un circuit de calcul 19 qui élabore la quantité x à partir des valeurs des grandeurs de transition et de la valeur préenregistrée de l'impédance $Z_L$ de la ligne dans le mode choisi. Des circuits à retard 17, 18 sont interposés entre les soustracteurs 15, 16 et le circuit 19 pour compenser le délai de transmission des valeurs des grandeurs $\Delta V_B$, $\Delta I_B$.

Un autre mode de mise en oeuvre du procédé selon l'invention avec l'utilisation de valeurs de grandeurs scalaires est illustré par la figure 4.

On retrouve, au point A, comme dans le cas de la figure 3, des dispositifs de mesure 41, 42 fournissant les valeurs de $V_A$ et $I_A$, des circuits de mémorisation 43, 44 recevant $V_A$ et $I_A$ et figés à l'apparition d'un défaut et des soustracteurs 45, 46 fournissant les valeurs instantanées de $\Delta V_A$ et $\Delta I_A$ après apparition du défaut. La valeur de $\Delta I_A$ est multipliée par $Z_L$ et les valeurs de $\Delta V_A$ et $Z_L\Delta I_A$ sont multipliées chacune par une même tension de référence $V_R$. Les produits obtenus sont intégrés au moyen d'intégrateurs respectifs 47, 48 sur une période T à compter de l'apparition du défaut, c'est-à-dire à compter de la réception du signal SD. Les valeurs obtenues pour les intégrales

$$\int \Delta V_A = \int_0^T \Delta V_A * V_R \quad \text{et} \quad \int Z_L \Delta I_A = \int_0^T Z_L \Delta I_A * V_R$$

sont mémorisées dans des mémoires respectives 49, 50.

De la même façon, au point B, on trouve des dispositifs de mesure 51, 52 fournissant les valeurs de $V_B$, $I_B$, des circuits de mémorisation 53, 54 recevant $V_B$ et $I_B$ et figés à l'apparition d'un défaut, des soustracteurs 55, 56 fournissant les valeurs instantanées de $\Delta V_B$ et $\Delta I_B$, des intégrateurs 57, 58 fournissant les valeurs des intégrales

$$\int \Delta V_B = \int_0^T \Delta V_B * V_R$$

$$\text{et} \quad \int Z_L \Delta I_B = \int_0^T Z_L \Delta I_B * V_R,$$

et des mémoires 59, 60 pour mémoriser les valeurs des intégrales.

Les valeurs des grandeurs $\Delta V_B$ et $Z_L\Delta I_B$ sont multipliées par une tension de référence $V_R$ identique à celle utilisée au point A, et les produits obtenus sont intégrés sur une même période T à partir de l'apparition d'un défaut que les produits similaires intégrés au point A. On élabore ainsi, de façon simultanée aux points A et B, et en temps réel, des grandeurs scalaires $\Sigma \Delta V_A$, $\Sigma Z_L\Delta I_A$, $\Sigma \Delta V_B$ et $\Sigma Z_L\Delta I_B$ homogènes à des énergies.

Les grandeurs scalaires élaborées au point B sont appliquées à des circuits d'émission 62, 63 où elles sont modulées, éventuellement après codage, et transmises au moyen d'une liaison 61 jusqu'au point A où elles sont démodulées et éventuellement décodées par des récepteurs 64, 65. Le calcul de x est effectué en différé en appliquant l'équation :

$$(4) \qquad x = \frac{\int \Delta V_A - \int \Delta V_B + \int Z_L \Delta I_B}{\int Z_L \Delta I_A + \int Z_L \Delta I_B}$$

Ce calcul est effectué au moyen d'un circuit de calcul 69 recevant les différentes grandeurs scalaires.

L'utilisation de grandeurs scalaires permet d'éviter une transmission en temps réel de l'extrémité B à l'extrémité A, avec compensation du délai de transmission, puisque la transmission et le calcul peuvent être effectués en différé. Du fait que l'on est ainsi libéré des problèmes de synchronisation, il n'est pas utile d'allouer intégralement un canal de communication à la transmission du signal concerné. Aussi, la transmission des grandeurs scalaires du point B au point A peut être avantageusement réalisée au moyen d'un canal de communication commuté ou fonctionnant en temps partagé.

La tension de référence $V_R$ doit être la même en A et en B. On peut utiliser la tension de service existant avant défaut et mémorisée.

Pour obtenir une même tension de référence, malgré l'influence du courant de charge préalable au défaut, on pourra par exemple utiliser la tension de ligne au milieu de la ligne 1, soit:
- au point A,

$$V_R = \frac{(V_{LA} - \frac{Z_L}{2} I_{LA})}{}$$

- au point B,

$$V_R = (V_{LB} - \frac{Z_L}{2} I_{LB}),$$

$V_{LA} = V_{LB}$ représentant la tension de ligne en A et en B et $I_{LA} = -I_{LB}$ représentant les courants de charge avant défaut.

Au point A, les grandeurs $V_{LA}$ et $I_{LA}$ sont fournies par des dispositifs de mesure 70, 71 dont les sorties sont combinées au moyen d'un circuit 72 fournissant

$$V_{LA} - \frac{Z_L}{2} I_{LA}.$$

La sortie du circuit 72 est appliquée à un circuit de mémorisation 73 qui délivre la tension $V_R$, le circuit de mémorisation 73 ayant par exemple une structure analogue à celle des circuits 13, 14.

De la même façon, au point B, les grandeurs $V_{LB}$ et $I_{LB}$ sont fournies par des dispositifs de mesure 75, 76, puis sont combinées par un circuit 77 pour fournir une grandeur

$$V_{LB} - \frac{Z_L}{2} I_{LB}$$

qui est appliquée à un circuit de mémorisation 78.

Le choix de la tension de référence $V_R$ telle que définie ci-dessus n'est pas limitatif, d'autres grandeurs pouvant être utilisées dans la mesure où elles permettent de disposer de références identiques aux deux extrémités de la ligne.

Par ailleurs, dans le cas de l'élaboration de grandeurs scalaires par intégration du produit de deux signaux alternatifs, il peut se produire que les deux signaux soient en quadrature ou sensiblement en quadrature, privant le procédé de mesure de toute sensibilité.

Pour éliminer ce risque, on pourra utiliser deux grandeurs de référence, par exemple la tension $V_R$ définie plus haut et une tension $V'_R$ obtenue par déphasage de $V_R$ de 90°. Les grandeurs scalaires élaborées à partir des mesures de $\Delta V_A$, $\Delta I_A$, $\Delta V_B$ et $\Delta I_B$ seront alors par exemple de la forme

$$\Sigma'\Delta V_A = \int_0^T \Delta V_A * V_R + \int_0^T \Delta V_A * V'_R$$

$$\Sigma' Z_L \Delta I_A = \int_0^T Z_L \Delta I_A * V_R + \int_0^T Z_L \Delta I_A * V'_R$$

$$\Sigma'\Delta V_B = \int_0^T \Delta V_B * V_R + \int_0^T \Delta V_B * V'R, \text{ et}$$

$$\Sigma' Z_L \Delta I_B = \int_0^T Z_L \Delta I_B * V_R + \int_0^T Z_L \Delta I_B * V'R.$$

**Revendications**

1. Procédé de localisation de défaut sur une ligne électrique à partir de mesures effectuées à chaque extrémité de la ligne sur laquelle un défaut a été détecté, la distance du défaut par rapport à une extrémité de la ligne étant calculée à partir des valeurs reçues et de la valeur de l'impédance de la ligne, lesdites valeurs étant reçues en un même point, caractérisé en ce que les mesures effectuées sont des mesures de grandeurs de transition non homopolaires, le défaut étant assimilé à une source de tension, en ce que les valeurs utilisées sont les valeurs soit des grandeurs de transition mesurées soit des grandeurs scalaires élaborées à partir des grandeurs de transition, la distance du défaut par rapport à une extrémité de la ligne étant calculée à partir des valeurs reçues et de la valeur de l'impédance de la ligne dans le mode correspondant aux grandeurs mesurées.

2. Procédé selon la revendication 1, caractérisé en ce que les grandeurs de transition mesurées sont choisies parmi les courants et tensions inverses, directes de transition, polaires de transition, de phase de transition et interphases de transition.

3. Procédé selon l'une quelconque des revendications 1, 2, caractérisé en ce que les valeurs des grandeurs de transition sont mesurées simultanément et transmises en temps réel en un même point de calcul de la distance du défaut.

4. Procédé selon l'une quelconque des revendications 1 à 3, caractérisé en ce que les grandeurs de transition sont transformées en grandeurs scalaires par intégration sur une même durée des produits des grandeurs de transition avec au moins une même grandeur de référence, et les valeurs des grandeurs scalaires sont transmises en un même point de calcul de la distance du défaut.

5. Procédé selon la revendication 4, caractérisé en ce que l'une au moins des grandeurs de référence est égale à une tension au milieu de la ligne.

6. Procédé selon l'une quelconque des revendications 4, 5, caractérisé en ce que chaque grandeur scalaire correspondant à une grandeur de transition est élaborée en combinant cette grandeur de transition avec deux grandeurs de référence en quadrature.

7. Procédé selon l'une quelconque des revendications 1 à 6, caractérisé en ce que le calcul de la distance du défaut est effectué à une première extrémité de la ligne, et les valeurs des grandeurs de transition mesurées à la deuxième extrémité de la ligne, ou des grandeurs scalaires élaborées à partir de celles-ci, sont transmises à la première extrémité de la ligne par un canal de communication commuté ou fonctionnant en temps partagé.

**Claims**

1. Method of locating faults on an electrical line based on measurements take at each end of the line on which a fault has been detected, the distance to the fault from one end of the line being calculated from values received and from the value of the line impedance, said values being received at a common point, characterised in that the measurements effected are measurements of non-homopolar transition magnitudes, the fault being treated as a voltage source, in that the values used are the values either of measured transition magnitudes or of scalar magnitudes deduced from transition magnitudes, the distance of the fault from one end of the line being calculated from the received values and from the value of the impedance of the line in the mode corresponding to the measured magnitudes.

2. Method according to claim 1 characterised in that the transition magnitudes measured are chosen from the reverse, transition forward, transition polar, transition phase and transition interphases currents and voltages.

3. Method according to claim 1 or claim 2 characterised in that the values of the transition magnitudes are measured simultaneously and transmitted in real time to a common point for calculating the distance to the fault.

4. Method according to any one of claims 1 to 3 characterised in that the transition magnitudes are converted into scalar magnitudes by integrating over a common period products of the transition magnitudes with at least one common reference magnitude and the values of the scalar magnitudes are transmitted to a common point for calculating the distance to the fault.

5. Method according to claim 4 characterised in that at least one of the reference magnitudes is equal to a voltage at the mid-point of the line.

6. Method according to claim 4 or claim 5 characterised in that each scalar magnitude corresponding to a transition magnitude is deduced by combining said transition magnitude with two reference magnitudes in phase quadrature.

7. Method according to any one of claims 1 to 6 characterised in that the distance to the fault is calculated at a first end of the line and the values of the transition magnitudes measured at the second end of the line or of the scalar magnitudes deduced therefrom are transmitted to the first end of the line over a switched or time-sharing communication link.

**Patentansprüche**

1. Verfahren zur Fehlerlokalisierung auf einer elektrischen Leitung ausgehend von Messungen, die an jedem Ende der Leitung durchgeführt werden, auf der der Fehler erfaßt wurde, wobei der Abstand des Fehlers in Bezug auf ein Ende der Leitung ausgehend von empfangenen Werten und von dem Wert der Impedanz der Leitung berechnet wird und wobei diese Werte in einem gleichen Punkt empfangen werden, dadurch gekennzeichnet, daß die durchgeführten Messungen Messungen von nicht-homopolaren Übergangsgrößen sind, wobei der Fehler einer Spannungsquelle gleichgesetzt wird, daß die verwendeten Werte die Werte entweder von gemessenen Übergangsgrößen oder von skalaren Größen sind, die ausgehend von den Übergangsgrößen erarbeitet wurden, wobei der Abstand des Fehlers von einem Ende der Leitung ausgehend von den empfangenen Werten und dem Wert der Impedanz der Leitung in dem den gemessenen Größen entsprechenden Modus berechnet wird.

2. Verfahren nach Anspruch 1, dadurch gekennzeichnet, daß die gemessenen Übergangsgrößen aus den umgekehrten, direkten Übergangs-, polaren Übergangs-, Phasenübergangs- und Zwischenphasenübergangs-Strömen und -Spannungen ausgewählt werden.

3. Verfahren nach einem beliebigen der Ansprüche 1, 2, dadurch gekennzeichnet, daß die Werte der Übergangsgrößen gleichzeitig gemessen und in Echtzeit an einen gemeinsamen Punkt zur Berechnung des Abstands des Fehlers übertragen werden.

4. Verfahren nach einem beliebigen der Ansprüche 1 bis 3, dadurch gekennzeichnet, daß die Übergangsgrößen in skalare Größen durch Integration der Produkte aus den Übergangsgrößen mit mindestens einer gleichen Bezugsgröße über eine gleiche Dauer umgewandelt werden und daß die Werte der skalaren Größen an einem gleichen Punkt zur Berechnung des Abstands des Fehlers übertragen werden.

5. Verfahren nach Anspruch 4, dadurch gekennzeichnet, daß mindestens eine der Bezugsgrößen gleich einer Spannung in der Mitte der Leitung ist.

6. Verfahren nach einem beliebigen der Ansprüche 4, 5, dadurch gekennzeichnet, daß jede einer Übergangsgröße entsprechende skalare Größe erarbeitet wird, indem diese Übergangsgröße mit zwei Bezugsgrößen in Quadratur kombiniert wird.

7. Verfahren nach einem beliebigen der Ansprüche 1 bis 6, dadurch gekennzeichnet, daß die Berechnung des Abstands des Fehlers an einem ersten Ende der Leitung durchgeführt wird, und daß die am zweiten Ende der Leitung gemessenen Werte der Übergangsgrößen oder der von diesen ausgehend erarbeiteten skalaren Größen zum ersten Ende der Leitung über einen durchgeschalteten oder in Zeitmultiplex arbeitenden Verbindungskanal übertragen werden.

Fig.1

Fig.2

Fig.3

Fig.4

EP 0 230 801 B1